# DEMANDE DE BREVET EUROPEEN

(11) **EP 2 006 902 A2**
(43) Date de publication de la demande: **24.12.2008**
(21) Numéro de dépôt: 08354041.9
(22) Date de dépôt: 17.06.2008
(51) Int. Cl.: H01L 21/768, H01L 23/532

(54) **Procédé de réalisation d'une connexion électrique à base de nanotubes gainés individuellement**

(30) Priorité: 22.06.2007 FR 0704463
(71) Demandeur: Commissariat à l'Energie Atomique, 75015 Paris (FR)
(72) Inventeur: Coiffic, Jean-Christophe, 38000 Grenoble (FR); Dijon, Jean, 38800 Champagnier (FR)
(74) Mandataire: Jouvray, Marie-Andrée

(57) **Abrégé**

Une connexion électrique, comportant des nanotubes (10), est réalisée entre deux couches en matériau métallique séparées par une couche (5) en matériau isolant. Après la croissance des nanotubes (10), leur alignement sensiblement perpendiculairement aux niveaux métalliques est effectué au moyen d'un champ électromagnétique d'alignement (E). Puis, un matériau de gainage (11) est déposé, recouvrant au moins partiellement les nanotubes (10) et assurant au moins le gainage individuel des nanotubes (10). Le champ électromagnétique d'alignement des nanotubes (10) est maintenu durant le dépôt du matériau de gainage.

## Description

### Domaine technique de l'invention

L'invention est relative à un procédé de réalisation d'une connexion électrique, comportant des nanotubes, entre deux couches en matériau métallique séparées par une couche en matériau isolant, les nanotubes étant au moins partiellement recouverts par au moins un matériau métallique.

### État de la technique

Les nanotubes de carbone font actuellement l'objet d'un effort important de recherche car leur structure cylindrique monoatomique leur confère des propriétés exceptionnelles à l'échelle nanométrique. Une application prometteuse consiste à utiliser les nanotubes dans les interconnexions, notamment dans l'industrie de la microélectronique, comme décrit par Nihei et al. (« Electrical Properties of Carbon nanotube Bundles for Future Via Interconnects » Japanese Journal of Applied Physics Vol. 44, N°4A, 2005, pp1626-1628). Ces interconnexions sont constituées par deux lignes de métal conductrices, actuellement en cuivre, situées l'une au-dessus de l'autre, formant ainsi deux niveaux métalliques reliés par des ponts conducteurs appelés vias.

Pour supporter les contraintes imposées par la réduction des dimensions ajoutée à une complexification des paramètres d'intégration, il est envisagé d'utiliser des nanotubes de carbone comme fils nanométriques métalliques pour les interconnexions. Ceux-ci possèdent en effet des propriétés intrinsèques très intéressantes par rapport au cuivre.

Une des difficultés liées à l'utilisation de nanotubes de carbone dans les interconnexions se situe notamment au niveau de la réalisation des contacts avec un matériau métallique à chaque extrémité du nanotube. La croissance des nanotubes se faisant du bas vers le haut, le contact inférieur se fait naturellement lors de la réalisation des nanotubes. Le contact de la partie supérieure pose plus de problèmes. Il s'agit en effet de connecter correctement le niveau métallique du contact supérieur tout en optimisant la surface de contact par rapport à la longueur totale des nanotubes.

Par ailleurs, la reprise de contact est d'autant plus difficile que les nanotubes utilisés pour ces interconnexions peuvent être localement courbés et enchevêtrés

Le brevet US 7135773 décrit une méthode de réalisation d'une interconnexion comportant des nanotubes de carbone qui relient deux niveaux métalliques en cuivre. Une fois les nanotubes réalisés dans le via, ce dernier est rempli par du cuivre qui assure le maintien mécanique des nanotubes. Cependant, en pratique, la structure décrite dans ce brevet ne peut pas réellement être réalisée avec des nanotubes de carbone mais seulement avec des nanofibres de carbone, plus rigides. En effet, le remplissage correct du via n'est possible que si les nanotubes, obtenus par croissance catalytique, sont alignés verticalement et surtout individuellement.

Le brevet US 6837928 décrit l'utilisation d'un champ électrique lors de la croissance ou postérieurement à la croissance de nanotubes pour réaliser leur alignement selon le champ électrique. Le champ électrique décrit est typiquement de l'ordre de 1 V/µm.

Le document WO-A-03/087707 décrit la métallisation des nanotubes de carbone afin de pouvoir aligner les nanotubes de carbone au moyen d'un champ magnétique agissant sur le métal.

La demande de brevet US 2005/0208304 décrit l'enrobage au moins partiel de nanotubes par un métal.

### Objet de l'invention

L'objet de l'invention consiste à réaliser une structure d'interconnexion à base de nanotubes qui soit facile à mettre en oeuvre et qui assure un contact performant entre les niveaux métalliques et les nanotubes.

Selon l'invention, ce but est atteint par un procédé selon les revendications annexées et plus particulièrement par le fait qu'il comporte, entre la croissance des nanotubes et le dépôt dudit matériau métallique, l'alignement des nanotubes sensiblement perpendiculairement aux niveaux métalliques au moyen d'un champ électromagnétique d'alignement, puis le dépôt d'un matériau de gainage recouvrant au moins partiellement les nanotubes et assurant au moins le gainage individuel des nanotubes, le champ électromagnétique d'alignement des nanotubes étant maintenu durant le dépôt du matériau de gainage.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 5 représentent de manière schématique, en coupe, les principales étapes de réalisation d'une structure d'interconnexion selon l'invention,
- les figures 6 et 7 représentent de manière schématique, en coupe, une variante de réalisation d'une structure d'interconnexion selon l'invention.

### Description de modes de réalisation préférentiels de l'invention

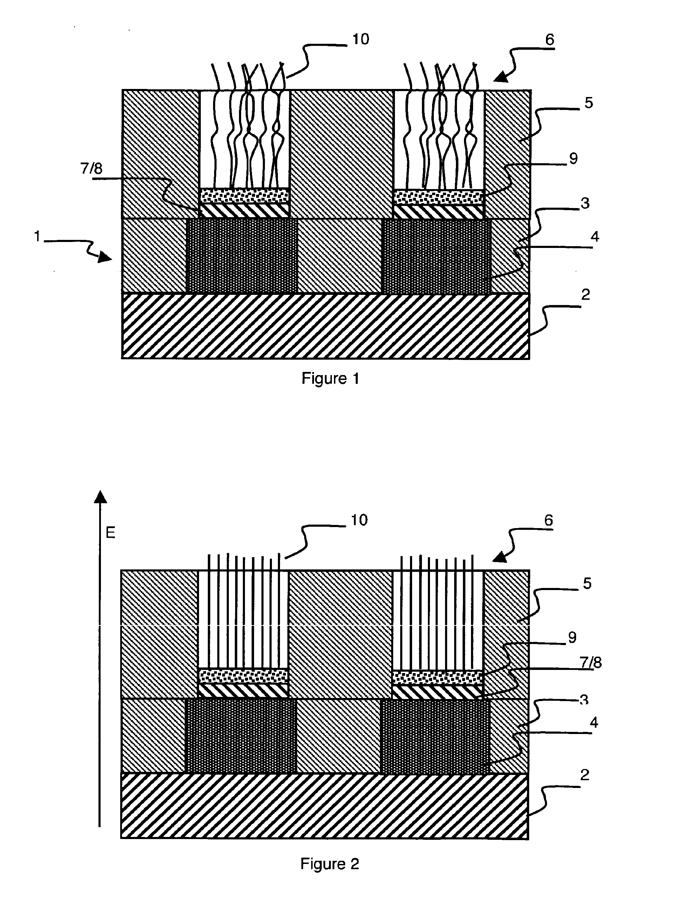

Comme illustré sur la figure 1, un premier niveau métallique 1 est réalisé sur un support 2. Le support 2 est, par exemple, constitué par un substrat de silicium et peut comporter une pluralité de couches. Le premier niveau métallique 1 est réalisé de manière classique et comporte une alternance entre un premier matériau isolant 3 et un premier matériau métallique 4. Le premier matériau métallique 4 forme ainsi des motifs au sein du premier matériau isolant 3, sur toute sa hauteur. Le premier matériau métallique 4 est par exemple en Cu, Al, W, Ag, Pt, Pd, Ti, TiN, Ta, TaN, Mo ou un de leurs alliages. Le premier matériau isolant 3 est réalisé dans un matériau ayant, de préférence, une constante diélectrique faible, par exemple de l'oxyde de silicium. Les épaisseurs des couches 3 et 4 sont typiquement celles utilisées dans une structure d'interconnexion métallique conventionnelle.

Une couche 5 en matériau isolant est alors déposée sur le premier niveau métallique 1. Cette couche 5 en matériau isolant est ensuite structurée, par toute technique adaptée, par exemple par photolithographie et gravure, de façon à former au moins un orifice 6 et ainsi à libérer l'accès à certains motifs en premier matériau métallique 4. Dans un premier mode de réalisation, la structuration de la couche 5 en matériau isolant permet de créer des orifices ou vias 6 sous la forme d'évidements ayant des parois latérales sensiblement verticales et rectilignes sur toute la hauteur de la couche 5 en matériau isolant.

Après structuration de la couche 5 en matériau isolant, le fond des vias 6 est alors matérialisé par des zones en premier matériau métallique 4 du premier niveau métallique 1. La forme des vias 6 est, de manière conventionnelle, carrée ou ronde, mais peut également présenter des formes diverses.

Comme illustré sur la figure 1, une couche d'accroche 7 et/ou une couche barrière 8 est ensuite, avantageusement, déposée sur l'ensemble de la structure. La couche d'accroche 7 permet de renforcer l'adhérence de la couche barrière 8 sur la couche 4. La couche d'accroche 7 est, par exemple, en Ta, TaN, TiN, Ti, Al, Ru, Mn, Mo, Cr, son épaisseur est avantageusement inférieure à 10nm et peut aller jusqu'au dépôt d'une couche atomique. La couche barrière 8, généralement utilisée pour éviter l'interdiffusion d'un catalyseur 9 avec le premier matériau métallique 4, est par exemple en Al, Al₂O₃, TiN, Ti, Ta, TaN, Mn, Ru, Mo. La couche barrière 8 peut également être auto-positionnée par dépôt chimique et auto-catalytique (« electroless » en anglais), c'est-à-dire qu'elle ne se dépose que sur les zones en premier matériau métallique 4. La couche barrière 8 est alors, par exemple, en CoWP, CoWB, CoWP/B, NiMoP, NiMoB ou tout métal et leurs alliages. La couche barrière 8 peut également être formée par une multicouche. La couche d'accroche 7 et la couche barrière 8 sont déposées par toute technique adaptée, par exemple, par évaporation, pulvérisation sous plasma de gaz neutre, par exemple de l'argon, de l'hélium ou de l'hydrogène. Avantageusement, si le premier matériau métallique 4 est en cuivre, une couche d'accroche 7 en Tantale (Ta) et une couche barrière 8 pouvant être en TaN, TiN ou Ru seront utilisées.

Une couche de catalyseur 9, destinée à permettre la croissance des nanotubes 10, est ensuite formée dans le fond des orifices 6. Le catalyseur 9 est, par exemple, en Co, Ni, Fe, Al, Al₂O₃, Mo. Le catalyseur 9 est déposé par toute technique adaptée. Cette couche est, par exemple, déposée sur le fond des orifices 6 et sur les faces supérieures de la couche 5 par dépôt directionnel, avec un apport de matière perpendiculairement au substrat 2. Le catalyseur peut également être auto-positionné et est alors, par exemple, en CoWP, CoWP/B, NiMoB, leurs oxydes ou leurs alliages. Dans certains cas de figure, le catalyseur 9 et la couche barrière 8 sont confondus et sont par exemple en CoWP, CoWP/B, NiMoB. Le catalyseur 9 peut être aussi déposé sous forme d'agrégats ou sous la forme d'une multicouche de différents matériaux.

Dans le cas où le catalyseur 9, la couche d'accroche 7 et/ou la couche barrière 8 sont déposées sur la couche 5 en matériau isolant, autour des orifices 6, ces couches sont éliminées à ces emplacements. Une élimination de ces matériaux est réalisée par tout moyen connu et notamment par gravure ou polissage mécano-chimique sur la couche 5 en matériau isolant. Ainsi le catalyseur 9 et les couches barrière 8 et/ou d'accroche 7 ne restent finalement présents que dans le fond des orifices 6.

La croissance des nanotubes 10, de préférence de carbone, est alors réalisée. La croissance des nanotubes 10 est réalisée de façon classique à partir du catalyseur 9 déposé sur le premier matériau métallique 4 au fond des orifices 6. La croissance des nanotubes 10 peut être réalisée par toute technique adaptée, par exemple par dépôt chimique en phase vapeur (CVD), dépôt chimique en phase vapeur assisté par plasma (PECVD), PECVD à résonance électron-cyclotron (Electron Cyclotron Resonance PECVD), dépôt chimique en phase vapeur avec filament à chaud, dépôt chimique en phase vapeur assisté laser... Préférentiellement, une technique permettant la croissance de nanotubes 10 de carbone à partir d'un catalyseur et à une température inférieure à 900°C est utilisée. Les gaz employés lors de la formation de nanotubes de carbone peuvent être du CO, C₂H₂, CH₄, Fe(C₅H₅)₂, du xylène, des métallocènes, les alcools à l'état gazeux et tous les gaz carbonés, H₂, NH₃, H₂O, O₂ ou un mélange de ces gaz. Le carbone peut également être apporté grâce à une sole en graphite, bombardée par un plasma.

La croissance des nanotubes 10 se fait depuis le fond des orifices 6, c'est-à-dire depuis le catalyseur 9, jusqu'à dépasser la hauteur de l'ouverture de l'orifice 6 dans la couche 5.

Pour obtenir des nanotubes 10 présentant tous la même orientation (figure 2), un champ électromagnétique d'alignement est appliqué après la croissance des nanotubes 10. Les caractéristiques du champ électromagnétique sont choisies pour que les nanotubes soient alors déployées et orientées sensiblement perpendiculaires au premier niveau métallique 1 et parallèles aux parois latérales des orifices 6.

Une seule des composantes, électrique ou magnétique, du champ électromagnétique peut être utilisée pour réaliser l'alignement des nanotubes 10. Dans le cas où un champ électrique est appliqué aux nanotubes 10 afin de les orienter, la composante électrique (E) est préférentiellement inférieure à la valeur seuil disruptive du gaz présent dans la chambre de dépôt. Avantageusement, un champ électrique inférieur à 100V/µm et encore plus avantageusement un champ de l'ordre de 1V/µm est appliqué au niveau des nanotubes. Ce champ électrique est, par exemple, appliqué au moyen d'électrodes disposées de part et d'autre de l'empilement substrat/niveau métallique/couche en matériau isolant. Avantageusement, la cible contenant la matière à déposer est située du coté de l'électrode où est appliquée la tension de polarisation.

Avantageusement, un système d'aimant permanent peut être utilisé pour forcer les électrons libres du plasma à rentrer en collision avec les atomes composant le gaz du plasma.

De cette manière, au moins la partie supérieure de chacun des nanotubes 10 est déployée individuellement et alignée selon le champ électrique. Les défauts géométriques des nanotubes 10 sont ainsi amoindris par la mise en forme rectiligne des nanotubes.

Les nanotubes 10 sont ensuite maintenus rectilignes et parallèles au moyen du champ électromagnétique d'alignement pendant qu'un matériau de gainage 11 est déposé. Le matériau de gainage 11 est déposé de façon conforme, c'est-à-dire qu'il épouse parfaitement la forme de la surface sur laquelle il se dépose. Le matériau de gainage 11 est, par exemple, en matériau conducteur, par exemple en carbone ou en métal choisi parmi Pd, Au, Ti, TiN, Al, Ta, TaN, Cr, Cu, Ag, Pt, Mo, Co, Ni, Fe, et tous leurs alliages. Cependant, le matériau de gainage 11 peut également être en matériau isolant, par exemple en Al₂O₃, MgO, SiO₂, SixNx, SiOC, TiO₂. Le matériau de gainage 11 peut être de nature hydrophobe ou hydrophile, il peut également être biocompatible et être déposé sous forme d'une ou plusieurs couches.

Avantageusement, les conditions du dépôt sont choisies afin que le dépôt du matériau de gainage 11 reste de type conforme le plus loin possible à l'intérieur du via. Un dépôt de type conforme étant réalisé sur chaque nanotube 10, la longueur et la surface de contact entre le matériau de gainage 11 et chaque nanotube sont nettement augmentées. Ainsi, si le matériau de gainage 11 est conducteur, la qualité du contact entre le nanotube 10 et le matériau de gainage est améliorée et tend vers un contact de type ohmique.

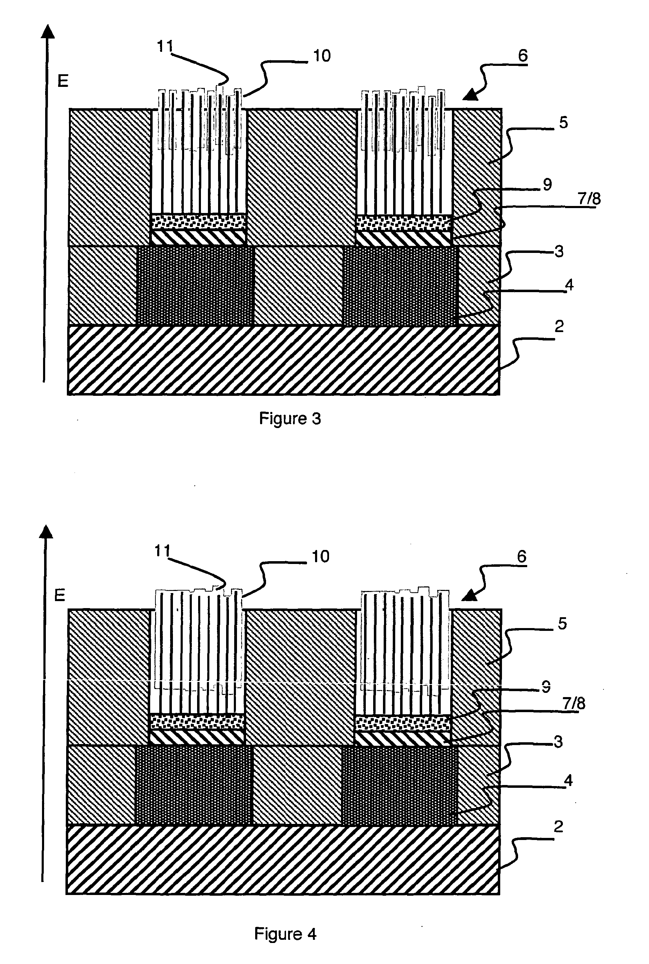

L'épaisseur du dépôt du matériau de gainage 11 est adapté en fonction des spécificités recherchées. Si, comme illustré à la figure 3, un dépôt ayant une longueur de contact maximale sans coalescence des nanotubes est recherchée, alors un dépôt mince, par exemple inférieur à 70nm est effectué. Si une étape ultérieure de polissage est prévue, l'épaisseur du dépôt est augmentée afin de former une coquille solide incorporant au moins la partie supérieure de tous les nanotubes (figure 4).

Après dépôt du matériau de gainage 11, qui a avantageusement une longueur de contact supérieur à 1µm, l'orientation des nanotubes 10 est définitive, c'est-à-dire même en l'absence de champ électromagnétique. En effet, le matériau de gainage 11 agissant comme une gaine autour de chaque nanotube 10, le champ électromagnétique est alors supprimé.

Avantageusement, une étape de recuit additionnelle est utilisée pour faire diffuser le matériau de gainage 11 et/ou pour former un alliage avec le nanotube 10 de carbone. Par exemple, si le matériau de gainage 11 est en titane, un alliage de TiC est formé.

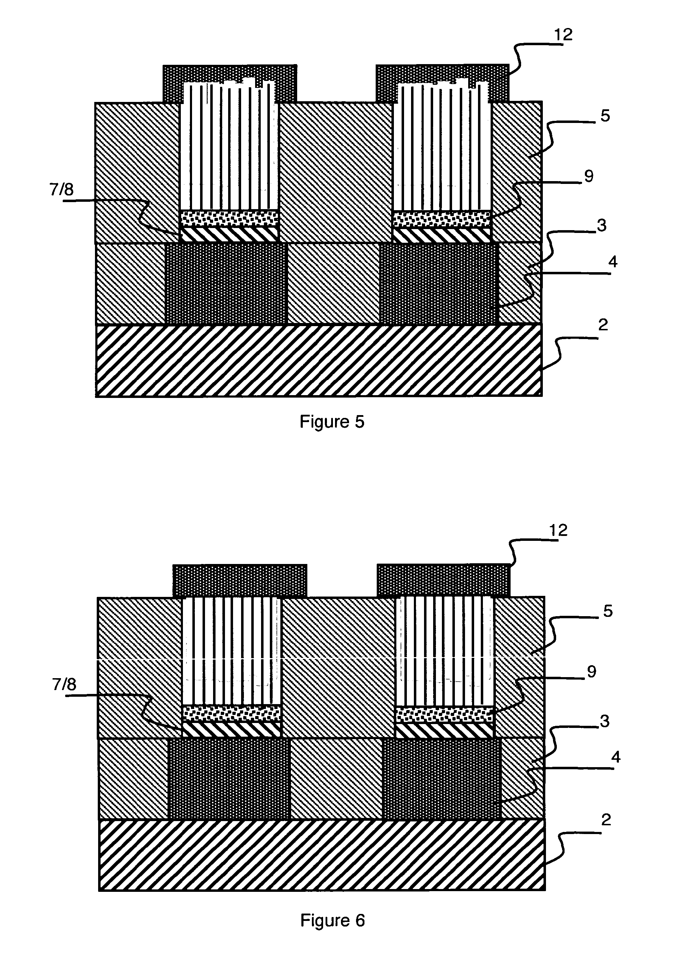

Comme illustré sur la figure 5, le dépôt d'un deuxième matériau métallique 12 est ensuite réalisé, puis structuré, de façon classique. Le deuxième matériau métallique 12 est par exemple en Cu, Au, Al, W, Ag, Pt, Pd, Ti, TiN, Ta, TaN, Mo ou un de leurs alliages et son épaisseur est préférentiellement comprise entre 5 nm et 100 µm. Les couches en premier 4 et deuxième 12 matériau métallique sont ainsi connectées électriquement au moyen des nanotubes 10. Dans ce mode de réalisation, la connexion des deux matériaux métalliques 4, 12 est essentiellement réalisée par les parois externes des nanotubes 10.

Dans une variante de réalisation, illustrée à la figure 6, une étape additionnelle de polissage est réalisée. Cette étape de polissage mécano-chimique est avantageusement utilisée afin de sectionner les extrémités supérieures des nanotubes 10 avant le dépôt de la couche en matériau métallique 12 et permettre ainsi l'accès du matériau 12 aux parois internes des nanotubes.

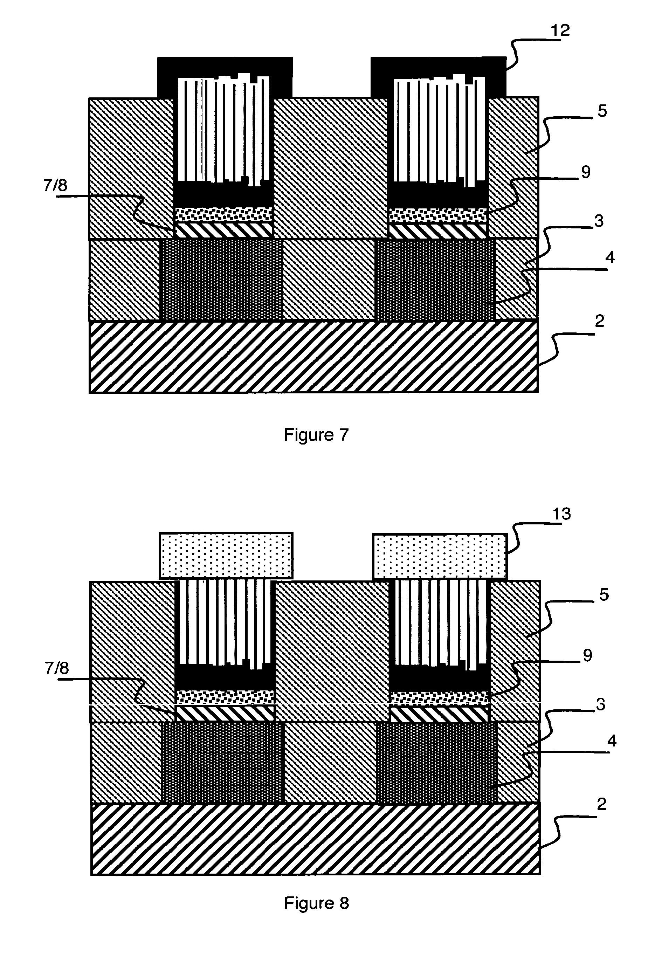

Dans une autre variante de réalisation, illustrée à la figure 7, afin d'obtenir des connexions électriques les plus conductrices possible, les orifices 6 sont remplis par un matériau métallique. Une fois le matériau de gainage 11 disposé sur l'essentiel de la longueur des nanotubes 10, un dépôt électrochimique est effectué pour remplir au moins partiellement l'orifice 6. Afin de faciliter le dépôt électrochimique, le matériau de gainage est choisi le plus conducteur possible. De cette manière, le matériau déposé électrochimiquement remplit l'orifice 6 et peut former également la couche en deuxième matériau métallique 12 au-dessus de la couche 5. Le matériau déposé par dépôt électrochimique est préférentiellement du cuivre. Il peut également être, par exemple, en Al, Au, Pd, Ag, Ni, Fe, Cr, Ti, Pt, C, Co, Mo, Ru, ou un alliage de ces derniers. Le matériau déposé par dépôt électrochimique peut aussi être un composé à transfert de charge, comme les sels de Bechgaard, tels que les sels à base de tetra-methyl tetra selenafulvalene (TMTSF) ou les sels de biséthyldithio-tétrathiafulvalène (BEDT-TTF) ou encore des sels de tetra-methyl tétrathiafulvalène (TMTTF). Avantageusement, lorsque le dépôt remplit complètement les interstices entre les nanotubes, il permet d'augmenter la conductivité de la structure d'interconnexion. De plus l'interconnexion est mécaniquement renforcée pour assurer, par exemple, une étape de polissage mécano-chimique.

Si le polissage est utilisé, par exemple, pour avoir accès aux parois internes des nanotubes 10, le dépôt d'un troisième matériau métallique 13 est ensuite effectué et structuré afin de réaliser un deuxième niveau métallique (figure 8). Le troisième matériau métallique 13 est, par exemple, en Cu, Al, W, Ag, Pt, Pd, Ti, TiN, Ta, TaN, Mo ou un de leurs alliages.

## Revendications

1. Procédé de réalisation d'une connexion électrique, comportant des nanotubes (10), entre deux couches (4, 12) en matériau métallique séparées par une couche (5) en matériau isolant, les nanotubes (10) étant au moins partiellement recouverts par au moins un matériau métallique, procédé **caractérisé en ce qu'**il comporte entre la croissance des nanotubes (10) et le dépôt dudit matériau métallique, l'alignement des nanotubes (10) sensiblement perpendiculairement aux niveaux métalliques au moyen d'un champ électromagnétique d'alignement, puis le dépôt d'un matériau de gainage (11) recouvrant au moins partiellement les nanotubes (10) et assurant au moins le gainage individuel des nanotubes (10), le champ électromagnétique d'alignement des nanotubes (10) étant maintenu durant le dépôt du matériau de gainage.

2. Procédé selon la revendication 1, **caractérisé en ce que** le matériau de gainage (11) enrobe au moins partiellement chaque nanotube (10), depuis son extrémité supérieure.

3. Procédé selon l'une des revendications 1 et 2, **caractérisé en ce que** le matériau de gainage (11) assure une connexion rigide et fixe entre les nanotubes (10) adjacents.

4. Procédé selon l'une quelconque des revendications 1 à 3, **caractérisé en ce que** le matériau de gainage (11) est un matériau conducteur

5. Procédé selon la revendication 4, **caractérisé en ce que** le matériau de gainage (11) est en carbone ou en métal choisi parmi Al, Au, Pd, Ag, Ru, Ni, Fe, Cr, Ti, Cu, Pt, W, Co, Mo.

6. Procédé selon la revendication 5, **caractérisé en ce qu'**un alliage entre le nanotube (10) et le matériau de gainage (11) est formé par recuit.

7. Procédé selon l'une quelconque des revendications 1 à 3, **caractérisé en ce que** le matériau de gainage (11) est un matériau isolant choisi parmi Al₂O₃, MgO, SiO₂, SixNx, SiOC, TiO₂.
